# FASCICULE DE BREVET EUROPEEN

(11) **EP 3 237 127 B1**
(45) Date de publication et mention de la délivrance du brevet: **10.04.2019**
(21) Numéro de dépôt: 15823679.4
(22) Date de dépôt: 18.12.2015
(51) Int. Cl.: C22B 15/00, B09B 3/00, A62D 3/20, B09B 5/00, H05K 3/22

(54) **PROCÉDÉ DE RECYCLAGE DE DÉCHETS D'ÉQUIPEMENTS ÉLECTRIQUES ET ÉLECTRONIQUES**
VERFAHREN ZUR WIEDERVERWERTUNG VON ELEKTRISCHEN UND ELEKTRONISCHEN ALTGERÄTEN
METHOD FOR RECYCLING WASTE ELECTRICAL AND ELECTRONIC EQUIPMENT

(30) Priorité: 23.12.2014 FR 1463195
(43) Date de publication de la demande: 01.11.2017
(73) Titulaire: BRGM, 45060 Orléans Cedex 2 (FR); Centre National de la Recherche Scientifique CNRS, 75794 Paris Cedex 16 (FR); Université d'Orléans, 45067 Orléans Cedex 2 (FR)
(72) Inventeur: MENAD, Nour-Eddine, 45100 Orleans (FR); GUIGNOT, Sylvain, 45000 Orleans (FR); GÖKALP, Iskender, 45000 Orleans (FR); BOSTYN, Stéphane, 45740 Lailly-en-Val (FR); GRATZ, Yann, 57000 Metz (FR); POIRIER, Jacques, 45750 Saint Privé-saint Mesmin (FR)
(74) Mandataire: McDade, Sophie V.G.A.
(86) Numéro de dépôt international: PCT/FR2015/053635
(87) Numéro de publication internationale: WO 2016/102849

(56) Documents cités:
- WO-A1-01/83834
- DE-A1-102010 011 937
- JP-A- H06 228 667
- JP-A- 2000 107 725
- US-A- 6 164 571
- US-A1- 2003 154 590
- US-A1- 2008 283 472
- XIU ET AL.: WASTE MANAGEMENT., vol. 33, 2013, pages 1251-1257, XP28531770, cité dans la demande

## Description

### 1 - Domaine technique de l'invention

L'invention concerne un procédé de recyclage des métaux contenus dans les cartes électroniques des déchets d'équipements électriques et électroniques (D3E ou DEEE).

### 2 - Etat de l'art

Une carte électronique est un circuit imprimé sur lequel sont soudés différents types de composants électroniques. Ces cartes sont retrouvées dans de nombreux équipements électriques et électroniques (EEE) tels que les téléphones portables, les imprimantes ou encore les ordinateurs. Elles sont généralement composées de 35% de métaux génériques et précieux, 35% de fibres de verre (ou fibres siliceuses) constituant l'armature de la carte, et de 30% de matières organiques telles que les plastiques et les résines. En termes de métaux précieux, on peut y retrouver de l'or dans les processeurs et sur les connections, du palladium dans les condensateurs céramique multicouche (MLCC) et quelques transistors, du tantale dans certains condensateurs et de l'argent dans les circuits intégrés.

Le tableau 1 montre des exemples de compositions de téléphones portables, ordinateurs personnels (PC) et leur impact sur la demande annuelle en métaux (UNEP 2013).

**Tableau 1**

| **Téléphones portables (a)** | | **PC & ordinateurs portables (b)** | | **Mines urbaines (a+b)** | |
|---|---|---|---|---|---|
| **1600 million unités / an** | | **350 Million unités / an** | | **Production minière Part** | |
| x 250 mg Ag ≈ | 400 t | x 1000 mg Ag ≈ | 350 t | Ag: 22,200 t/a | 3 % |
| x 24 mg Au ≈ | 38 t | x 220 mg Au ≈ | 77 t | Au: 2,500 t/a | 5 % |
| x 9 mg Pd ≈ 1 | 4 t | x 80 mg Pd ≈ | 28 t | Pd: 200 t/a | 21 % |
| x 9 g Cu ≈ | 14 000 t | x ∼500 g Cu ≈ | 175 000 t | Cu:16Mt/a | 1 % |

Les volumes de vente globales de ces dispositifs donnent à penser qu'ils contiennent des quantités importantes de métaux.

On connaît déjà plusieurs procédés de recyclage de métaux (cf. Delfini et al. 2011. Journal of Environmental Protection. 2, 675-682). Ainsi, des cartes électroniques issues pour la plupart de rebuts de production sont traitées par hydrométallurgie afin de recycler l'or qu'elles contiennent. D'autres cartes électroniques sont traitées par pyrolyse pour éliminer la résine et concentrer les métaux précieux. Les métaux précieux sont ensuite récupérés par voies pyrométallurgique et hydrométallurgique. Ces procédés sont nocifs pour l'environnement car ils nécessitent l'utilisation de solvants organiques. En effet en ce qui concerne le traitement par pyrolyse, les métaux obtenus à partir de ce procédé sont encrassés et doivent ensuite être soumis à un traitement hydrométallurgique. De plus, le traitement par pyrométallurgie nécessite un broyage préalable à une granulométrie fine qui est associé à une consommation énergétique importante. Ce broyage fin est responsable de la majorité des pertes de métaux dans les poussières.

L'eau supercritique peut être utilisée seule ou en combinaison avec une espèce générant de l'oxygène (type eau oxygénée) afin d'oxyder la matière organique. Un fluide est dit supercritique lorsqu'il est placé dans des conditions de température et de pression au-delà de son point critique. Le couple température et pression du point critique de l'eau est Tc = 374 °C, Pc = 22,1 MPa. Dans ces conditions supercritiques, l'eau présente des propriétés de solvatation proches de celles d'un solvant organique de type hexane.

Dans le cas d'un mélange H₂O/O₂ le taux de destruction des molécules organiques peut atteindre 99,99 %, avec, comme composés gazeux rejetés, du CO₂, du N2, de l'O₂ en excès, voire du CO en traces si la température de la réaction est inférieure à 500 °C. Ainsi la technologie d'oxydation en eau supercritique peut générer, sous les conditions appropriées, des effluents directement compatibles avec l'environnement.

En parallèle, et du fait de la diminution de la constante diélectrique et de la constante ionique de dissociation de l'eau dans ces gammes de températures et de pressions, la solubilité des sels minéraux diminue fortement.

La réaction d'oxydation de la matière organique est exothermique, ce qui permet, pour des taux de matière organique dans l'effluent supérieurs à environ 4 % massique, de disposer d'un procédé autonome en énergie de chauffage (cf. Moussière et al. 2007. The Journal of Supercritical Fluids. 43, 324-332).

On connaît de Xiu et al. (2013. Waste Management. 33, 1251-1257) un procédé de recyclage de métaux comportant une étape de traitement en conditions supercritiques. Le solvant utilisé est de l'eau, avec ou sans agent oxydant (eau oxygénée). Dans ce procédé, le traitement en conditions supercritiques est effectué sur des cartes électroniques préalablement broyées à une granulométrie inférieure à 3 mm. L'étape de traitement en conditions supercritiques est effectuée dans un milieu réducteur ou dans un milieu oxydant. Lors de cette étape, la matière organique est détruite et éliminée dans les effluents. Cette étape est ensuite suivie par une séparation des fibres siliceuses par de l'acide chlorhydrique.

Ce procédé de l'état de la technique nécessite donc une étape préalable de broyage à une granulométrie très fine, ce qui, comme le traitement par pyrométallurgie, génère des poussières et entraîne des pertes de métaux. L'étape de broyage fin est également associée à une consommation importante d'énergie. Le document DE 10 2010 011937 A1 décrit un procédé de traitement dans lequel les déchets sont fragmentés en préalable à un pré-traitement en milieux aqueux en conditions supercritiques.

### Description de l'invention

L'invention a pour objectif de proposer un procédé alternatif ne présentant tout ou partie de ces inconvénients et permettant un recyclage amélioré de métaux présents dans les cartes électroniques.

A cet effet, l'invention a pour objet un procédé de séparation de métaux de cartes électroniques caractérisé en ce qu'il comprend :
a) une étape de traitement desdites cartes électroniques, fragmentées ou non, dans un milieu aqueux en conditions supercritiques dudit milieu et
b) une étape ultérieure d'écrasement des matériaux à l'état solide issus de l'étape de traitement en conditions supercritiques.

Dans le procédé de l'invention, la fragmentation des matériaux de départ, si elle est utilisée, est avantageusement effectuée à des granulométries plus grossières que les traitements conventionnels. Contrairement à l'enseignement de l'art antérieur cette fragmentation de taille moins fine ne diminue pas le rendement, mais l'augmente en évitant ou minimisant substantiellement les pertes dues à la création de poussières issues du broyage.

L'objectif de la fragmentation est notamment d'obtenir des fragments de taille suffisamment réduite pour qu'ils puissent être introduits dans le réacteur dans lequel a lieu le traitement en conditions supercritiques. Ainsi, pour un traitement dans un réacteur d'une relativement grande contenance, il peut ne pas être nécessaire de broyer les cartes électroniques. Le procédé peut donc être utilisé sur des cartes complètes. Ce mode de réalisation particulier est donc avantageux car il ne requiert pas de dispositif pour le déchiquetage. Il est également plus rapide. Dans ce mode de réalisation, le risque de perte de matériaux est également diminué parce-que le procédé ne comporte pas, par rapport aux autres modes de réalisation, d'étape de transfert des matériaux.Cependant pour des réacteurs de plus faible contenance, la fragmentation peut s'avérer nécessaire.

Une fragmentation « grossière » peut également être avantageuse pour permettre un transport facile, éviter la perte des métaux dans les poussières générées et/ou pour augmenter la surface d'échange entre l'eau et le matériau et ainsi accélérer la cinétique de dégradation. ou optimiser la surface de matériau traitée. Ainsi, la granulométrie moyenne des fragments obtenus à l'issu d'une étape de fragmentation peut aller de 0,5 à 15 cm, de préférence de 0,8 à 10 cm et de façon encore plus préférentielle de 1 à 5 cm.

On entend par « granulométrie moyenne », la granulométrie, c'est-à-dire la mesure de la plus grande dimension représentée par au moins 60 %, de préférence au moins 75 % et de manière encore plus préférée 90 % des fragments.

Ces valeurs sont déterminées par tamisage dans des grilles de mailles adaptées aux granulométries à mesurer.

La fragmentation est effectuée par déchiquetage ou par broyage, par exemple au moyen d'un broyeur à couteaux.

De façon avantageuse, le broyeur est équipé d'une grille permettant d'effectuer la classification des fragments issus du broyage.

Dans l'étape a) de traitement en conditions supercritiques, c'est-à-dire dans des conditions où la température est supérieure à 374°Ctandis que la pression est supérieure à 22 ,1 MPa, la matière organique est détruite et éliminée dans les effluents. La résine des cartes électroniques est attaquée ce qui libère les fibres siliceuses, ainsi que les métaux. Les produits obtenus à l'issue de cette étape sont constitués majoritairement des métaux présents initialement dans les cartes. A l'inverse, la résine constituant le matériau, et composée de plastiques et de fibres, est en grande partie éliminée par l'attaque en conditions supercritiques. Cependant, des fibres et de la résine peuvent rester accrochées à la partie solide des cartes électroniques. Cette étape du procédé génère très peu de pertes en métaux. En effet, la phase liquide contient très peu d'éléments métalliques et la quasi-totalité des métaux sont récupérés dans la phase solide du traitement par eau supercritique.

De façon avantageuse, la température dans le milieu va de 374°C à 600°C pour une pression de 22,1 MPa à 30 MPa. De façon préférentielle, la température est supérieure à 500°C et préférentiellement égale à 600 ± 20 °C. En effet, aux conditions de température inférieure à 500 °C, il peut y avoir rejet de traces de monoxydede carbone.

Avantageusement, les conditions supercritiques du milieu aqueux sont maintenues pendant une durée supérieure ou égale à 30 minutes et préférentiellement allant de 60 minutes à 180 minutes.

De façon optionnelle, le milieu dans lequel est effectué le traitement en conditions supercritiques, contient de l'oxygène (par exemple de l'air) ou une ou des espèces générant de l'oxygène, et notamment de l'eau oxygénée. L'ajout d'un oxydant améliore la réaction. De plus l'ajout d'un catalyseur tel qu'un métaux alcalin (par exemple Na₂CO₃, KHCO₃,K₂CO₃, KOH, et/ou NaOH) et/ou du charbon actif peut également améliorer la réaction.

De façon optionnelle, le traitement est réalisé dans un autoclave et les conditions supercritiques sont atteintes par augmentation de la température, et de préférence exclusivement par augmentation de la température.

Avantageusement, le procédé selon l'invention comprend une étape de recyclage du milieu aqueux utilisé. Le liquide résultant de la réaction en conditions supercritiques entre les cartes électroniques et le fluide supercritique utilisé peut comprendre une phase huileuse. Les différentes phases du milieu réactionnel sont séparées. La phase huileuse, si celle-ci existe, peut-être séparée de la phase aqueuse par décantation. La phase aqueuse peut alors être purifiée par ajout de sels sulfatés et précipitation de son principal polluant qui est généralement le baryum. La phase liquide peut alors être réutilisée comme milieu aqueux du procédé de l'invention, avec éventuellement un ajout d'eau oxygénée en entrée de réacteur.

La phase solide peut être récupérée par filtration.

Dans l'étape b) d'écrasement des matériaux à l'état solide issus de l'étape de traitement en conditions supercritiques, les métaux sont séparés des fibresqui y étaient demeurées collées. La séparation est basée sur la différence de ductilité des matériaux en présence. En effet lors de l'écrasement, les phases métalliques ductiles sont aplaties, tandis que les fibres siliceuses s'effritent, entraînant une modification de la granulométrie de l'échantillon. Les parties effritées sont appelées des « fines ».

Au sens de l'invention, on entend par « écrasement », l'action d'aplatir et de déformer un corps par une forte compression et ou par un choc violent. L'écrasement est avantageusement effectué en déplaçant l'objet faisant compression sur l'objet compressé.

De façon avantageuse, une pression allant de 0,08 à 3 kPa par gramme de matériau traité, et préférentiellement de 0.1 à 2 kPa par gramme est exercée.

Métaux et fines peuvent aisément être séparés par une étape classique de tamisage. Cette technique de séparation présente l'avantage de ne pas nécessiter de broyage préalable des cartes et d'être associée à un bon rendement. Elle ne consomme pas de réactif et ne génère pas d'effluents. Enfin, cette étape de séparation permet de récupérer les fibres siliceuses.

Avantageusement, l'écrasement a lieu dans un émotteur qui est, de façon préférentielle, un tamis rotatif à éléments pesants. Les éléments pesants peuvent être des barres ou des boulets. Ils sont en général au moins au nombre de deux. Ils sont en un matériau auquel les métaux et les fibres siliceuses n'adhèrent pas dans les conditions d'hygrométrie, de température et de pression de l'étape b), tels que du fer. Leur masse est comprise entre **50 et 500 g par gramme de matériau traité, et préférentiellement entre 100 et 200 g par gramme.** La taille des mailles du tamis peut varier de 1 à 10 mm, de préférence de 2 à 5 mm et plus particulièrement de 1 à 3 mm (par exemple environ 2 mm).

De façon préférentielle, l'émotteur a une vitesse de rotation de l'ordre de 20 à 100 rpm, de prérence 40 à 80 rpm, et encore plus préférentiellement de 50 à 70 rmp.

Du fait que l'écrasement a lieu dans un tamis, la classification (c'est-à-dire la séparation) des fines et des particules métalliques est effectuée directement en sortie d'émotteur.

De façon avantageuse, les matériaux écrasés sont traités de manière à séparer les fragments d'une taille inférieure à 3 mm, préférentiellement inférieure à 2 mm et encore plus préférentiellement inférieure à 1 mm.

De façon préférentielle, les matériaux écrasés sont soumis à une séparation magnétique à basse intensité, préférentiellement sous un champ magnétique allant de 200 à 600 Gauss, préférentiellement de 300 à 500 Gauss et encore plus préférentiellement de 375 à 425 Gauss.

L'invention a également pour objet l'utilisation pour la séparation de métaux de cartes électroniques de moyens de traitement en milieu aqueux en conditions supercritiques et de moyens d'écrasement, éventuellement associés à des moyens de fragmentation. Cette utilisation peut être effectuée aux conditions et avec les moyens décrites dans la présente demande.

L'invention à également pour objet un dispositif associant les moyens précités aux conditions décrites dans la demande. Par exemple il peut combiner un réacteur comprenant un milieu supercritique à un émotteur tels que décrit dans la présente demande.

L'invention sera mieux comprise à la lecture des exemples, comprenant des figures, qui vont suivre, qui sont donnés uniquement à titre d'exemple.

### Description des figures :

La Figure 1 schématise les étapes d'un mode de réalisation du procédé de recyclage des cartes électroniques selon l'invention exemplifié aux exemples 1 à 3.
La Figure 2 présente l'émotteur utilisé pour écraser les cartes électroniques dans les exemples 1 à 3 de mise en oeuvre.
La Figure 3 est une photographie prise au microscope électronique à balayage (MEB) représentant l'aspect morphologique de la partie solide obtenue après fragmentation selon l'exemple 3.
Les Figure 4 à 6 regroupent les analyses chimiques qualitatives locales par microscopie électronique à balayage - spectroscopie à dispersion d'énergie (MEB EDS) réalisées sur la partie solide obtenue à l'issue de la fragmentation selon l'exemple 3, lors de sa visualisation au MEB.
La Figure 7 est une photographie prise au MEB représentant l'aspect des fines obtenues à l'issue de l'écrasement selon l'exemple 3.
La Figure 8 présente une analyse chimique qualitative locale réalisée par MEB EDS en un point de la fraction des fines obtenue à l'issue de l'écrasement selon l'exemple 3.
La figure 9 présente un tableau regroupant les clichés des produits obtenus aux exemples 1 et 2 après attaque à l'eau supercritique en présence d'eau oxygénée.

### Exemples 1 et 2

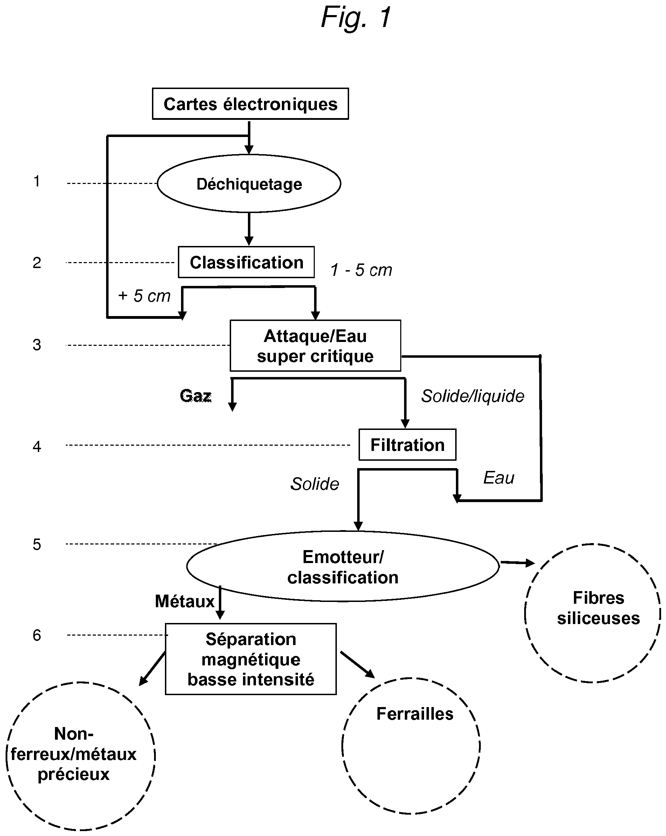

Dans un premier exemple, des cartes électroniques d'ordinateurs portables ont été soumises à une fragmentation au moyen d'un broyeur à couteaux muni d'une grille d'une maille de 5 cm. Il s'agit de l'étape 1 (« déchiquetage ») du procédé schématisé en Figure 1. Dans cet exemple, la fragmentation avait pour objectif l'obtention de fragments de taille généralement supérieure à 1 cm et inférieure à 5 cm. A l'issue de la fragmentation, les fragments sont soumis à une classification (étape 2 du procédé schématisé en Figure 1). Les fragments de taille supérieure à 5 cm sont à nouveau soumis à l'étape 1 de déchiquetage. Les fragments de taille inférieure sont soumis à l'étape 3 du procédé schématisé en Figure 1. Plus précisément, 30 g de fragments ainsi obtenus ont ensuite été introduits dans un autoclave de 300 ml de volume dans lequel ils ont été mis en contact avec 30 g d'une solution aqueuse d'eau oxygénée de concentration de 33 % en masse. La température dans l'autoclave a été montée à 600 °C ce qui a permis d'atteindre une pression de 250 bars. Ces conditions de pression et de température ont été atteintes en environ 30 minutes. Les fragments ont ensuite été maintenus dans ces conditions pendant 30 minutes, puis l'autoclave a été dépressurisé.

La phase solide a ensuite été séparée de la phase liquide par filtration sur papier filtre de porosité de 2,5 µm, de façon à récupérer la totalité de la phase solide (Etape 4 du procédé schématisé en Figure 1).

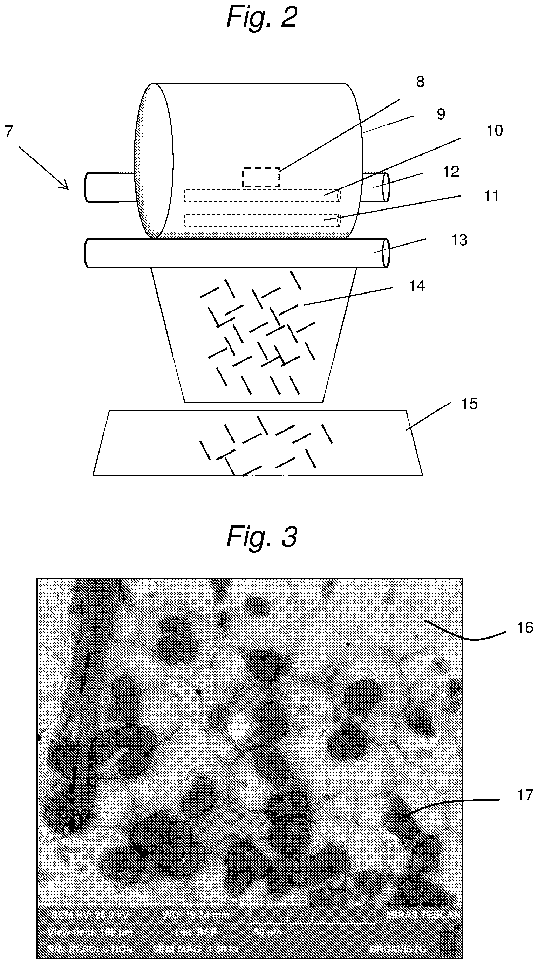

La phase solide a alors été passée dans un émotteur représenté en figure 2, qui est un exemple de l'émotteur indiqué à l'étape 5 du procédé schématisé en Figure 1.

La figure 2 représente un émotteur 7 qui est un tamis rotatif à éléments pesants, également utilisé dans les exemples 1 à 3 en tant que classificateur. Des résidus solides 8 issus de l'attaque en conditions supercritiques (étape 3 du procédé) sont placés dans un tamis cylindrique 9 qui présente une maille de 2 mm et contient deux barres pesantes 10 et 11. Les barres pesantes 10 et 11 sont des cylindres chacune de 15 cm de longueur, de 4 cm de diamètre et de 1,9 kg de masse. Le dispositif est fermé et positionné sur deux barres 12 et 13 positionnées à l'extérieur du tamis 9. Ces barres sont mises en rotation ce qui entraîne la rotation du tamis, assurant ainsi la mise en mouvement des barres pesantes 10 et 11 et l'écrasement des résidus solides 8. Cet écrasement libère les parties effritables 14 de la résine initiale qui collent encore sur les résidus solides 8. Ces parties effritées 14, appelées « fines », passent les ouvertures du tamis et sont récupérées en bas, à une granulométrie moyenne inférieure à 2 mm, dans des plateaux dédiés 15. Le temps d'écrasement a été environ de 3 minutes, temps au bout duquel il n'y avait plus, visuellement, de particules fines sortant du tamis. La matière restant dans le tamis est appelée « solides » et est récupérée. Les « fines » et les « solides » sont alors pesés.
Les métaux ainsi séparés de la résine peuvent ensuite être soumis à une séparation magnétique à basse intensité, sous un champ magnétique de 400 Gauss. Les métaux non ferreux, dont les métaux précieux, ont ainsi été séparés des ferrailles.

Le procédé décrit à l'exemple 1 a été réitéré dans un autre exemple, exemple 2, mais la durée pendant laquelle les fragments de cartes électroniques ont été maintenus dans les conditions supercritiques est de 2 heures une fois la montée en pression et température effectuée, et non 30 minutes comme dans l'exemple 1. Le temps d'écrasement a été environ de 1 minute 30 secondes, temps au bout duquel il n'y avait plus, visuellement, de particules sortant du tamis.

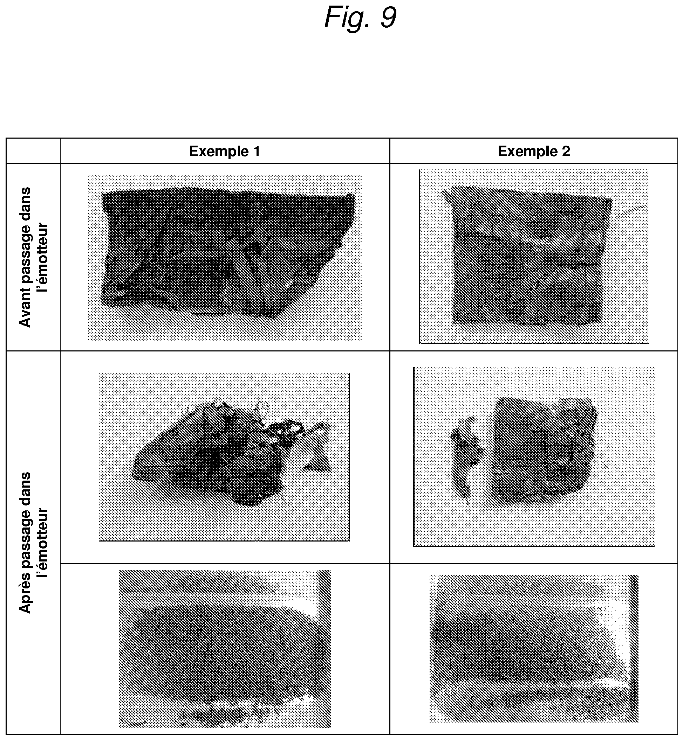

La figure 9 regroupe les clichés des produits obtenus après l'attaque à l'eau supercritique en présence d'eau oxygénée des exemples 1 et 2.

Le Tableau 3 indique les masses de fines et de solides obtenus respectivement dans les exemples 1 et 2.

**Tableau 3**

| | **Oxydation supercritique 2 h** | | **Oxydation supercritique 30 min** | |
|---|---|---|---|---|
| **Fines** | 3,91 g | *43,9 %* | 5,95 g | *51,0 %* |
| **Solide** | 5,00 g | *56,1 %* | 5,72 g | *49,0 %* |
| **TOTAL** | 8,91 g | *100 %* | 11,67 g | *100 %* |

L'aspect des produits avant leur passage dans l'émotteur à barres suggère une meilleure dégradation de la résine au bout de deux heures de traitement. Le pourcentage plus petit de fines pour le produit obtenu après oxydation supercritique de deux heures confirme cette observation. Par ailleurs, la durée de l'écrasement est également deux fois plus courte.

### Exemple 3

Dans un troisième exemple, une carte électronique d'ordinateur portable a été soumise, comme dans les exemples 1 et 2, à un déchiquetage au moyen d'un broyeur à couteaux muni d'une grille d'une maille de 5 cm. Les fragments obtenus ont une taille moyenne de 5 cm.

30 g des fragments ainsi préparés ont ensuite été introduits dans un autoclave de 300 ml de volume dans lequel ils ont été mis en contact avec 30 g d'eau. La température dans l'autoclave a été montée à 600 °C ce qui a permis datteindre une pression de 250 bars. Ces conditions de pression et de température ont été atteintes en environ 30 minutes. Les fragments ont ensuite été maintenus dans ces conditions pendant 60 minutes, puis l'autoclave a été dépressurisé.

La phase solide a ensuite été séparée de la phase liquide par filtration sur papier filtre de porosité de 2,5 µm, de façon à récupérer la totalité de la phase solide.

La phase solide a alors été passée pendant une durée d'environ 1 à 3 minutes dans l'émotteur décrit en Figure 2, jusqu'à ce qu'il n'y ait plus, visuellement, de particules sortant du tamis. Les parties ainsi effritées ont été récupérées et présentent une granulométrie inférieure à 2 mm.

Les métaux ainsi séparés de la résine peuvent être soumis à une séparation magnétique à basse intensité, sous un champ magnétique de 400 Gauss. Les métaux non ferreux, dont les métaux précieux, ont ainsi été séparés des ferrailles.

La Figure 3 présente un cliché au microscope électronique de la partie solide obtenue à l'issue du passage dans l'émotteur représenté en Figure 2. Le solide présente une surface claire (16) d'apparence homogène et des dépôts sombres (17) sur cette surface.

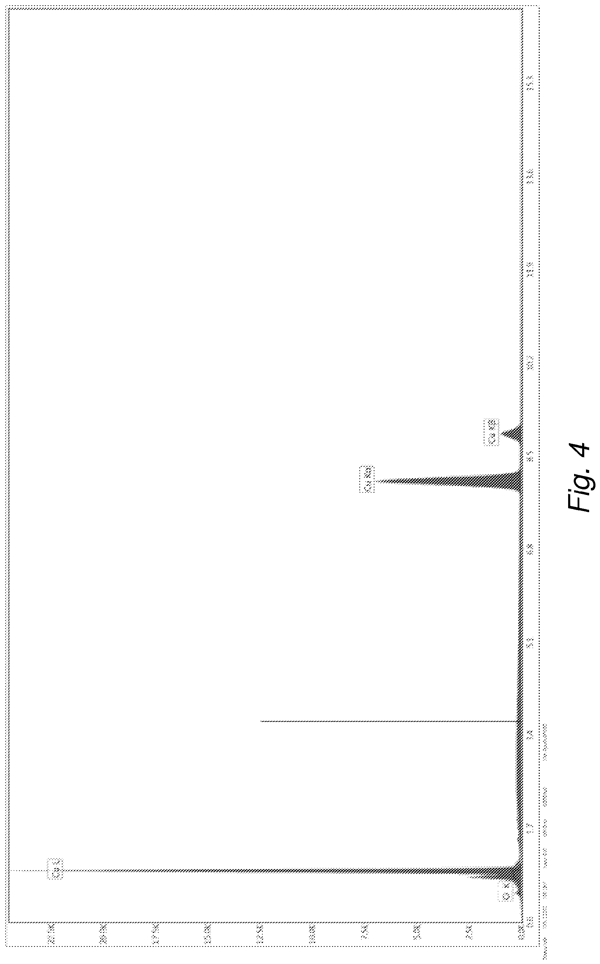

Une détermination de la composition chimique locale a été réalisée par MEB EDS dans des zones distinctes de la carte visualisée en Figure 3. Plus précisément, une analyse a été réalisée sur la zone claire (16) de la carte, et deux analyses ont été réalisées sur deux des zones plus sombres (17). Les résultats sont présentés sur les Figures 4 (analyse de la zone claire) et 5 et 6 (analyse des zones sombres).

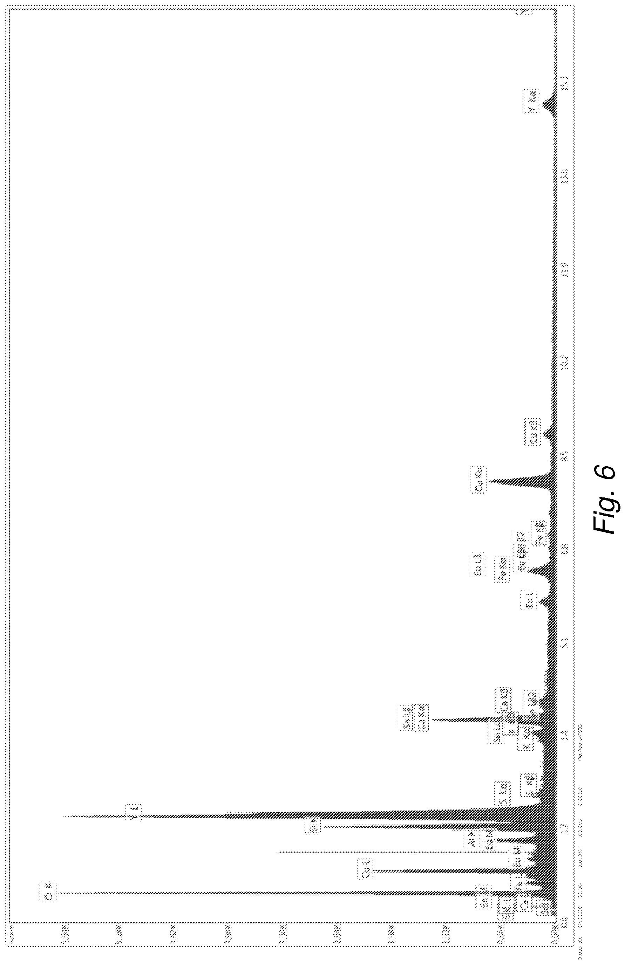

Dans l'analyse par MEB EDS, un flux d'électrons bombarde l'échantillon et provoque une émission de photons X, dont le spectre d'énergie caractérise les éléments constitutifs du matériau à analyser. Ce spectre est analysé par un détecteur semi-conducteur qui produit des pics de tension proportionnels à l'énergie des photons reçus (principe de la spectroscopie à dispersion d'énergie ou Energy Dispersive Spectroscopy, EDS). Les pics de tension obtenus permettent de quantifier les éléments émettant à une énergie donnée, exprimés en kiloélectron volts (keV). A titre d'exemple, la Figure 6 montre en particulier le pic d'émission de l'yttrium, niveau L (Y L), à environ 1,9 keV.

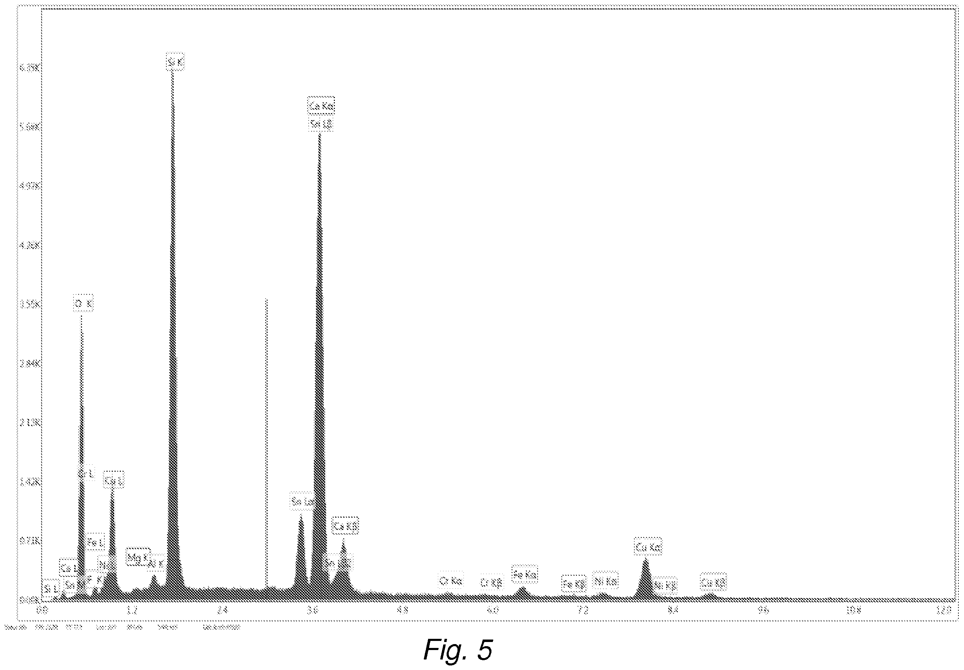

Ainsi, la Figure 4 montre une zone composée de cuivre métallique quasiment pur. A l'inverse, les Figure 5 et Figure 6 montrent peu de cuivre mais beaucoup d'oxydes de calcium, étain, europium et yttrium.

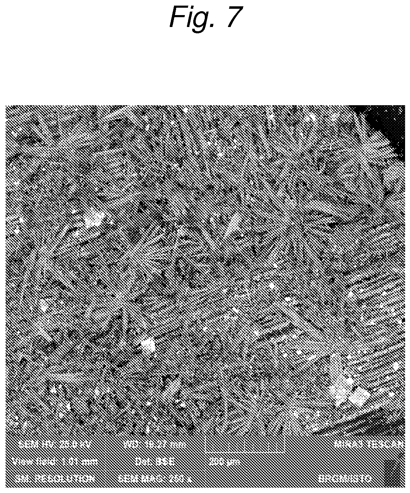

Une caractérisation similaire à celle réalisée pour les solides purs a été menée sur les fines récupérées après l'écrasement et constituées des fibres de l'armature de la carte. Le cliché pris au MEB (Figure 7) présente une assemblée de particules aciculaires, c'est-à-dire sous forme d'aiguilles et d'apparence homogène. Du fait que les fibres initiales ont une forme d'aguille et que la résine n'a pas de forme particulière, il apparaît que les fines contiennent principalement des fibres. L'eau supercritique a donc attaqué principalement la résine de la carte électronique et non les fibres.

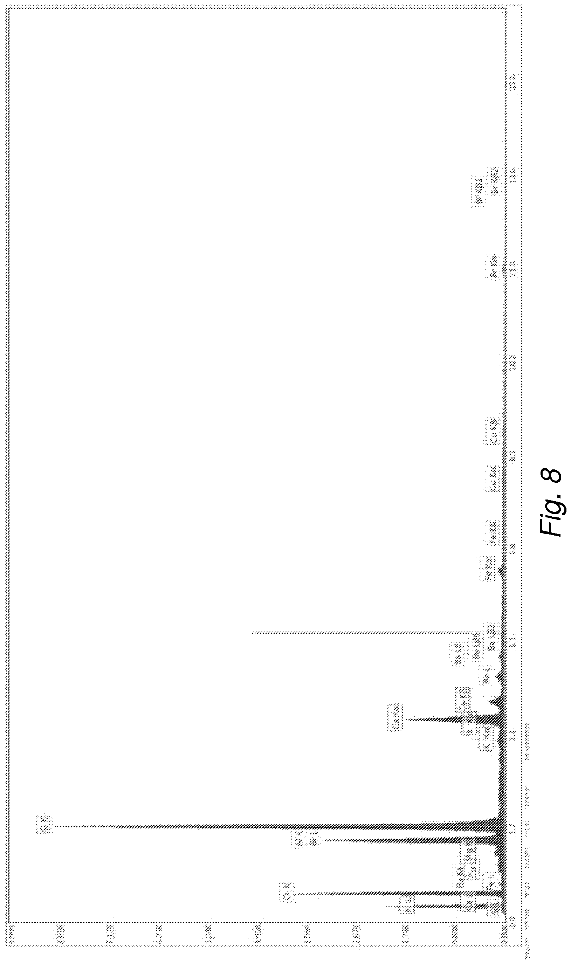

Ceci est confirmé par les résultats d'analyse de la composition chimique locale par MEB EDS (Figure 8). Cette analyse permet d'identifier les fibres de verre de la carte (oxydes de silicium, calcium et aluminium, traces de baryum). L'analyse met en évidence du cuivre, mais sous forme d'ultra-traces.

Le Tableau 4 présente les données de composition chimique de la phase liquide en sortie de l'étape d'attaque par eau supercritique, à l'issue de la filtration (étape 4 de la Figure 1) des produits de l'exemple 1.

**Tableau 4**

| **Eléments** | **Ag** | **Al** | **As** | **Ba** | **Be** | **Cd** | **Co** | **Cr** |
|---|---|---|---|---|---|---|---|---|
| Teneur ppm | 0,44 | 0,22 | 0,07 | 420,95 | 0,00 | 0,22 | 0,01 | 0,00 |

| **Eléments** | **Cu** | **Li** | **Mn** | **Ni** | **Pb** | **Sn** | **Sr** | **Zn** |
|---|---|---|---|---|---|---|---|---|
| Teneur ppm | 81,55 | 1,49 | 1,40 | 2,34 | 0,32 | 0,00 | 13,69 | 0,27 |

Il apparaît que la phase liquide contient très peu d'éléments métalliques, en particulier Ag et Cu. La quasi-totalité des métaux sont ainsi récupérés dans la phase solide du traitement par eau supercritique. L'analyse chimique de la fraction des fines obtenues après écrasement (Figure 8) met également en évidence une absence de cuivre. Le procédé présenté permet donc de récupérer la quasi-intégralité du cuivre dans une phase solide, qui peut être par la suite traitée par hydrométallurgie. Avantageusement, la phase solide peut être, préalablement au traitement hydrométallurgique, soumise à séparation magnétique afin d'éliminer les particules ferreuses.

## Revendications

1. Procédé de séparation de métaux de cartes électroniques **caractérisé en ce qu'**il comprend :
a) une étape de traitement desdites cartes électroniques, fragmentées ou non, dans un milieu aqueux en conditions supercritiques dudit milieu et
b) une étape ultérieure d'écrasement des matériaux (8) à l'état solide issus de l'étape de traitement en conditions supercritiques.

2. Procédé de séparation selon la revendication 1 dans lequel dans l'étape a), les cartes électroniques ne sont pas fragmentées.

3. Procédé de séparation selon la revendication 1 dans lequel les cartes électroniques sont soumises à une étape de fragmentation préalablement au traitement en conditions supercritiques et sont réduites en fragments de taille supérieure ou égale à 1 cm et inférieure ou égale à 5 cm.

4. Procédé de séparation selon l'une quelconque des revendications précédentes dans lequel ledit milieu contient de l'oxygène ou une ou des espèces générant de l'oxygène, et notamment de l'eau oxygénée.

5. Procédé de séparation selon l'une quelconque des revendications précédentes dans lequel les conditions de température et de pression appliquées au milieu vont de 374°C à 600°C et de 22,1 MPa à 30 MPa.

6. Procédé de séparation selon l'une quelconque des revendications précédentes dans lequel on maintient lesdites conditions supercritiques du milieu aqueux pendant une durée supérieure ou égale à 30 minutes et préférentiellement allant de 60 minutes à 180 minutes.

7. Procédé de séparation selon l'une quelconque des revendications précédentes dans lequel pour l'étape de traitement en conditions supercritiques, la température est supérieure à 500 °C et préférentiellement égale à 600° C.

8. Procédé de séparation selon l'une quelconque des revendications précédentes dans lequel les matériaux écrasés sont traités de manière à séparer les fragments (14) d'une taille inférieure à 2 mm.

9. Procédé de séparation selon l'une quelconque des revendications précédentes dans lequel l'étape a) est réalisée dans un autoclave et les conditions supercritiques sont atteintes par augmentation de la température, et de préférence exclusivement par augmentation de la température.

10. Procédé de séparation selon l'une quelconque des revendications précédentes dans lequel les matériaux écrasés sont soumis à une séparation magnétique à basse intensité, préférentiellement sous un champ magnétique de 400 Gauss.

11. Utilisation pour la séparation de métaux de cartes électroniques de moyens de traitement en milieu aqueux en conditions supercritiques et de moyens d'écrasement (10, 11) selon le procédé de, l'une quelconque des revendications précédentes, éventuellement associés à des moyens de fragmentation.

## Patentansprüche

1. Verfahren zum Trennen von Metallen elektronischer Leiterplatten, **dadurch gekennzeichnet, dass** es Folgendes umfasst:
a) einen Schritt zum Behandeln der zertrümmerten oder unzertrümmerten elektronischen Leiterplatten in einem wässrigen Medium bei superkritischen Bedingungen für das Medium und
b) einen weiteren Schritt zum Quetschen der Materialien (8) in festem Zustand, die aus dem Schritt zum Behandeln bei superkritischen Bedingungen hervorgegangen sind.

2. Trennverfahren nach Anspruch 1, wobei in Schritt a) die elektronischen Leiterplatten nicht zertrümmert werden.

3. Trennverfahren nach Anspruch 1, wobei die elektronischen Leiterplatten einem Schritt zum Zertrümmern vor dem Behandeln bei superkritischen Bedingungen unterzogen werden und in Bruchstücke einer Größe größer oder gleich 1 cm und kleiner oder gleich 5 cm reduziert werden.

4. Trennverfahren nach einem der vorhergehenden Ansprüche, wobei das Medium Sauerstoff oder eine oder mehrere Gattungen, die Sauerstoff erzeugen, und insbesondere mit Sauerstoff angereichertes Wasser enthält.

5. Trennverfahren nach einem der vorhergehenden Ansprüche, wobei die Temperatur- und Druckbedingungen, mit denen das Medium beaufschlagt wird, von 374 °C bis 600 °C und von 22,1 MPa bis 30 MPa reichen.

6. Trennverfahren nach einem der vorhergehenden Ansprüche, wobei die superkritischen Bedingungen für das wässrige Medium während eines Zeitraums größer oder gleich 30 Minuten und vorzugsweise von 60 Minuten bis 180 Minuten aufrechterhalten werden.

7. Trennverfahren nach einem der vorhergehenden Ansprüche, wobei bei dem Schritt des Behandelns bei superkritischen Bedingungen die Temperatur größer als 500°C und vorzugsweise gleich 600°C ist.

8. Trennverfahren nach einem der vorhergehenden Ansprüche, wobei die zerquetschten Materialien so behandelt werden, dass die Bruchstücke (14) mit einer Größe kleiner als 2 mm getrennt werden.

9. Trennverfahren nach einem der vorhergehenden Ansprüche, wobei der Schritt a) in einem Autoklaven durchgeführt wird und die superkritischen Bedingungen durch Erhöhung der Temperatur erreicht werden, und vorzugsweise ausschließlich durch Erhöhung der Temperatur.

10. Trennverfahren nach einem der vorhergehenden Ansprüche, wobei die zerquetschten Materialien einer magnetischen Trennung mit geringer Stärke unterzogen werden, vorzugsweise in einem Magnetfeld mit 400 Gauß.

11. Verwendung bei der Trennung von Metallen elektronischer Leiterplatten von Mitteln zum Behandlung in wässrigem Medium bei superkritischen Bedingungen und von Quetschmitteln (10, 11) nach einem der vorhergehenden Ansprüche, gegebenenfalls in Verbindung mit Zertrümmerungsmitteln.

## Claims

1. Process for separating metals from electronic boards, **characterized in that** it comprises:
a) a step of treating said optionally fragmented electronic boards in an aqueous medium under supercritical conditions of said medium and
b) a subsequent step of crushing the materials (8) in the solid state that are derived from the step of treating under supercritical conditions.

2. Separation process according to Claim 1, wherein, in step a), the electronic boards are not fragmented.

3. Separation process according to Claim 1, wherein the electronic boards are subjected to a fragmentation step prior to the treatment under supercritical conditions and are reduced to fragments having a size greater than or equal to 1 cm and less than or equal to 5 cm.

4. Separation process according to any one of the preceding claims, wherein said medium contains oxygen or one or more oxygen-generating species, and in particular hydrogen peroxide.

5. Separation process according to any one of the preceding claims, wherein the temperature and pressure conditions applied to the medium range from 374°C to 600°C and from 22.1 MPa to 30 MPa.

6. Separation process according to any one of the preceding claims, wherein said supercritical conditions of the aqueous medium are maintained for a duration greater than or equal to 30 minutes and preferably ranging from 60 minutes to 180 minutes.

7. Separation process according to any one of the preceding claims, wherein, for the step of treating under supercritical conditions, the temperature is above 500°C and preferentially equal to 600°C.

8. Separation process according to any one of the preceding claims, wherein the crushed materials are treated so as to separate the fragments (14) having a size of less than 2 mm.

9. Separation process according to any one of the preceding claims, wherein step a) is carried out in an autoclave and the supercritical conditions are achieved by increasing the temperature, and preferably exclusively by increasing the temperature.

10. Separation process according to any one of the preceding claims, wherein the crushed materials are subjected to a low-intensity magnetic separation, preferably under a magnetic field of 400 gauss.

11. Use, for the separation of metals from electronic boards, of means for treating in an aqueous medium under supercritical conditions and of crushing means (10, 11) according to the process of any one of the preceding claims, optionally combined with fragmentation means.
